# EUROPÄISCHE PATENTSCHRIFT

(11) **EP 1 920 646 B1**
(45) Veröffentlichungstag und Bekanntmachung des Hinweises auf die Patenterteilung: **01.04.2009**
(21) Anmeldenummer: 06760826.5
(22) Anmeldetag: 16.08.2006
(51) Int. Cl.: H05K 13/08, G01N 3/00

(54) **VORRICHTUNG ZUR PRÜFUNG VON WERKSTÜCKEN**
DEVICE FOR EXAMINING WORKPIECES
DISPOSITIF POUR VERIFIER DES PIECES

(30) Priorität: 16.08.2005 AT 13742005
(43) Veröffentlichungstag der Anmeldung: 14.05.2008
(73) Patentinhaber: MIDAS PRIVATE EQUITY GMBH, 83435 Bad Reichenhall (DE)
(72) Erfinder: SCHMIDBAUER, Manfred, A-5020 Salzburg (AT); KRETSCHMER, Michael, A-5020 Salzburg (AT); STAUDINGER, Gerold, A-5421 Adnet (AT)
(74) Vertreter: Babeluk, Michael
(86) Internationale Anmeldenummer: PCT/AT2006/000341
(87) Internationale Veröffentlichungsnummer: WO 2007/019596

(56) Entgegenhaltungen:
- EP-A1- 1 333 263
- US-A- 4 794 800

## Beschreibung

Die Erfindung betrifft eine Vorrichtung zur Prüfung von Werkstücken, insbesondere von Schaltplatinen mit einem Prüfwerkzeug, das in einem Messkopf eingespannt ist, der relativ zum Werkstück in einer Werkstückebene bewegbar ist, und mit einer optischen Beobachtungseinrichtung zur Steuerung des Messkopfes.

Bei der Herstellung von Schaltplatinen oder anderen elektronischen Bauteilen ist es vielfach erforderlich, die Qualität von Lötverbindungen zu testen. Dabei wird beispielsweise die Kontaktierung eines Mikroprozessors mit den entsprechenden Punkten auf der Platine untersucht, indem ein Werkzeug, das als kleiner Haken ausgeführt ist, unter die Verbindungsdrähte eingeführt wird und danach die Verbindungsdrähte mit Hilfe des Hakens abgerissen werden. Die Kraft, die erforderlich ist, um die Verbindungsdrähte abzureißen, wird gemessen und ist ein Maß für die Qualität der Lötverbindung. Da sowohl die zu untersuchenden Werkstücke als auch das Werkzeug naturgemäß sehr klein ausgebildet sind, ist die Steuerung der Bewegung mit hoher Genauigkeit auszuführen und daher schwierig. Analog dazu kann ein Werkstück auch zerstörungsfrei untersucht werden.

Es sind Vorrichtungen bekannt, die als Bond-Tester bezeichnet werden und mit denen die oben beschriebenen Untersuchungen durchgeführt werden können. Dabei ist ein Werkzeug auf einem Messkopf relativ zum Werkstück beweglich angeordnet, um die entsprechenden Messungen durchführen zu können. Die Steuerung erfolgt durch eine Bedienungsperson, die das Werkstück und das Werkzeug über ein an der Vorrichtung angebrachtes Mikroskop beobachtet. Die Durchführung der Arbeiten erfordert höchste Geschicklichkeit und ist fehleranfällig, da die Genauigkeit der Messung wesentlich davon abhängt, ob das Werkzeug lagengenau und richtig unter die entsprechenden Drahtverbindung eingeführt wird. Darüber hinaus sind die Untersuchungen zeitaufwändig und daher kostenintensiv.

Eine effiziente automatische Steuerung des Messkopfes in Bezug auf das Werkzeug konnte bisher nicht realisiert werden, da die Relativposition der Werkzeugspitze in Bezug auf den Messkopf geringfügigen Veränderungen unterworfen ist und somit nicht mit der erforderlichen Genauigkeit festgelegt werden kann. Diese Veränderungen rühren zum einen daher, dass das Werkzeug notwendigerweise über eine Kraftmesseinrichtung mit dem Messkopf verbunden ist, wodurch sich ein gewissen Spiel zwangsläufig ergibt. Weiters ist das Werkzeug im Verhältnis zu seinen Abmessungen hoch belastet und kann im Zuge von Messungen geringfügig verformt werden, was weitere Unsicherheitsfaktoren und Toleranzen mit sich bringt.

Die DE 199 15 052 A stellt eine optische Prüfeinrichtung zur Inspektion einer dreidimensionalen Oberflächenstruktur dar. Die Kamera, bzw. der optische Sensor wird durch eine Kalibriermarke kalibriert, wobei beispielsweise Kenngrößen für die Auflösung des optischen Sensors gewonnen werden können. Aussagen über die Werkzeugposition können nicht gewonnen werden.

Aufgabe der vorliegenden Erfindung ist es, die oben beschriebene Vorrichtung so weiterzuentwickeln, dass eine automatische Durchführung von Messvorgängen möglich ist, wobei durch eine Erhöhung der Positioniergenauigkeit die Zuverlässigkeit der Messungen gesteigert werden kann und gleichzeitig eine schnellere und kostengünstigere Messung möglich wird.

Eine weitere Aufgabe der Erfindung ist es, ein Verfahren anzugeben, mit dem die Überprüfung von Werkstücken zuverlässig, schnell und kostengünstig möglich ist.

Erfindungsgemäß werden diese Aufgaben dadurch gelöst, dass die optische Beobachtungseinrichtung als Kamera ausgebildet ist, die am Messkopf angebracht ist und die eine optische Achse aufweist, die im Wesentlichen senkrecht auf die Werkstückebene ist, und dass eine Kalibrierungseinrichtung vorgesehen ist, um den mechanischen Offset, das ist der Abstand des Werkzeuges von der optischen Achse der Kamera, zu bestimmen.

Wesentlich an der vorliegenden Erfindung ist, dass die Bewegung des Messkopfes durch eine Kamera gesteuert wird, die auf das Werkstück gerichtet ist und somit die exakte Position des Messkopfes in Bezug auf das Werkstück feststellen kann. Ein wesentlicher Unterschied zum Stand der Technik besteht dabei in der Tatsache, dass die Kamera nicht notwendigerweise den Vorgang des Eingriffs des Werkzeuges in das Werkstück beobachtet, sondern nur zu Positionierung dient. Dies ist deshalb wesentlich, da eine hohe Genauigkeit nur mit Kameras erzielt werden kann, die entsprechend kleine Bildwinkel und dementsprechend eine hohe Auflösung aufweisen, so dass es aufgrund der baulichen Gegebenheiten für die Kamera gar nicht möglich ist, das Werkzeug direkt zu beobachten. Die im Zeitablauf leicht veränderliche Position der Werkzeugspitze in Bezug auf den Messkopf durch die oben beschriebenen Ungenauigkeiten, Toleranzen oder plastischen Verformungen wird dadurch Rechnung getragen, dass vor der Messung eine Kalibrierung erfolgt, bei der das Werkzeug mit einer Kalibriereinrichtung lagemäßig erfasst wird. Da nach Durchführung des Kalibriervorganges die genaue Relativposition der Werkzeugspitze in Bezug auf die Kamera bekannt ist, kann der Messkopf entsprechend bewegt werden, um einen sicheren Eingriff des Werkzeuges zu erreichen.

Wenn in der obigen Beschreibung oder in weiterer Folge davon die Rede ist, dass der Messkopf relativ zum Messkopf bewegbar ist, so soll diese Formulierung sowohl den Fall umfassen, bei dem das Werkstück fest eingespannt ist und der Messkopf beweglich ist, als auch den Fall, bei dem der Messkopf fest und das Werkstück entsprechend beweglich ist. Die Bewegung erfolgt dabei in an sich bekannter Weise in der Form eines Koordinatentisches, wie er etwa bei einem Plotter ausgeführt ist.

Für die Kalibrierungseinrichtung werden mehrere besonders bevorzugte Ausführungsvarianten vorgeschlagen. Eine erste Ausführungsvariante ist dabei so ausgebildet, dass die Kalibrierungseinrichtung als weitere Kamera ausgebildet ist, die relativ zu Messkopf beweglich und so ausrichtbar ist, dass das Werkzeug und Referenzpunkte des Messkopfes von der weiteren Kamera erfassbar sind. Beim Kalibriervorgang wird dabei der Messkopf so bewegt, dass das Werkzeug in den Erfassungsbereich der weiteren Kamera gelangt. Durch Erfassung von Referenzpunkten, die am Messkopf angebracht sind, ist es dann möglich, die Relativposition des Werkstückes zur Kamera festzustellen. Die Referenzpunkte können beispielsweise am Objektiv der Kamera angebracht sein oder es wird das Objektiv selbst als Referenzpunkt erfasst. An sich ist es möglich durch eine entsprechende Ausbildung der weiteren Kamera gleichzeitig das Werkzeug und die Referenzpunkte zu erfassen, um den Abstand beziehungsweise die Relativposition zu bestimmten. Besonders bevorzugt ist es jedoch, wenn die Erfassung hintereinander erfolgt, wobei zunächst die Werkzeugspitze in die optische Achse der weiteren Kamera gebracht wird und danach der Messkopf so verfahren wird, dass ein Referenzpunkt ebenfalls in der optischen Achse der weiteren Kamera liegt. Durch Bestimmung des Verfahrweges des Messkopfes kann die genaue Relativposition festgelegt werden. Selbstverständlich ist es auch möglich, zuerst den Referenzpunkt und danach die Werkzeugspitze zu positionieren.

Eine alternative Kalibrierungseinrichtung ist durch ein Prisma gebildet, das an geeigneter Stelle neben dem Werkstück angeordnet ist. Das Prisma ist dabei so ausgebildet, dass die optische Achse der Kamera um 180° so umgelenkt wird, dass diese auf die Werkzeugspitze gerichtet ist. Aufgrund der bekannten Abmessungen und optischen Eigenschaften des Prismas kann dann auf die Relativposition zwischen Kamera und Werkzeugspitze rückgeschlossen werden.

Eine weitere besonders begünstigte Ausführungsvariante der vorliegenden Erfindung ist dadurch gekennzeichnet, dass die Kalibrierungseinrichtung als Öffnung in einer Aufnahme für das Werkstück ausgebildet ist, in welche Öffnung das Werkzeug einführbar ist und dass die Öffnung durch die Kamera optisch erfassbar ist. Der Kalibriervorgang wird dabei so ausgeführt, dass die Werkzeugspitze durch entsprechendes Verfahren des Messkopfes in die Kalibrierungsöffnung eingeführt wird, so dass die Position des Messkopfes genau feststellbar ist. Ähnlich wie beim oben beschriebenen Verfahren kann dies entweder gleichzeitig erfolgen, indem bei eingeführtem Werkzeug durch die Kamera weitere Referenzpunkte erfasst werden, deren Relativposition zur Kalibrierungsöffnung bekannt ist, woraus der mechanische Offset genau bestimmt werden kann oder aber es wird in bevorzugter Weise nach dem Einführen der Werkzeugspitze in die Kalibrierungsöffnung eine entsprechende Bewegung des Messkopfes ausgeführt, um die Kalibrierungsöffnung selbst in den Erfassungsbereich zu bringen. Eine besonders genaue Kalibrierung kann erreicht werden, wenn das Werkzeug über eine Messeinrichtung verfügt, die zur Steuerung der Einführbewegung in die Kalibrierungsöffnung ausgebildet ist. Auch eine konische Ausbildung der Kalibrierungsöffnung ist in dieser Hinsicht vorteilhaft.

In einer besonders begünstigten Ausführungsvariante der erfindungsgemäßen Vorrichtung ist vorgesehen, dass das Werkzeug als Haken ausgebildet ist, der über eine Zugkrafterfassungseinrichtung am Messkopf befestigt ist. Die Zugkrafterfassungseinrichtung produziert dabei ein Signal, das die Kraft angibt, die erforderlich ist, um die zu prüfende Verbindung zu zerstören.

Besonders bevorzugt ist es, wenn die Werkstückebene in Gebrauchslage der Vorrichtung im Wesentlichen waagrecht ist und dass das Werkzeug im Messkopf senkrecht beweglich angeordnet ist.

Weiters ist es von besonderem Vorteil, wenn das Werkzeug gegenüber dem Messkopf drehbar angeordnet ist. Es können dadurch Prüfvorgänge unabhängig von der Orientierung der jeweiligen Kontakte vorgenommen werden.

Im Hinblick auf die Automatisierbarkeit der Vorrichtung ist es besonders günstig, wenn die Vorrichtung mit einer Bilderkennungseinrichtung zur automatischen Bewegung des Werkzeuges ausgestattet ist. Dabei kann insbesondere die äußere Form der elektronischen Bauteile, deren Kontaktierung zu überprüfen ist, vorgegeben sein, um eine sichere Steuerung zu gewährleisten.

Weiters betrifft die vorliegende Erfindung ein Verfahren zur Prüfung von Werkstücken mit folgenden Schritten:
- Einspannen eines Werkstückes;
- Bereitstellen eines Werkzeuges auf einem Messkopf, der relativ zum Werkstück gelagert ist; Führen des Werkzeuges zu den zu untersuchenden Punkten des Werkstückes, geführt durch eine optische Beobachtungseinrichtung; Durchführen der Messung an den zu untersuchenden Punkten des Werkstückes.

Erfindungsgemäß ist dieses Verfahren dadurch gekennzeichnet, dass die Führung des Werkzeuges durch eine Kamera erfolgt, die gemeinsam mit dem Werkzeug relativ zum Werkstück beweglich ist und dass die Relativposition der Kamera zum Werkzeug durch eine Kalibrierungseinrichtung erfasst wird. Ein solches Verfahren ist schneller, genauer, zuverlässiger und kostengünstiger als bekannte Verfahren, die mit bekannten Vorrichtungen ausgeführt werden.

In der Folge wird die vorliegende Erfindung anhand der in den Figuren dargestellten Ausführungsbeispiele näher erläutert. Es zeigen schematisch:
- Fig. 1: eine erste Ausführungsvariante einer erfindungsgemäßen Vorrichtung in einer seitlichen Ansicht;
- Fig. 2 und Fig. 3: weitere Ausführungsvarianten in Darstellungen entsprechend der Fig. 1.

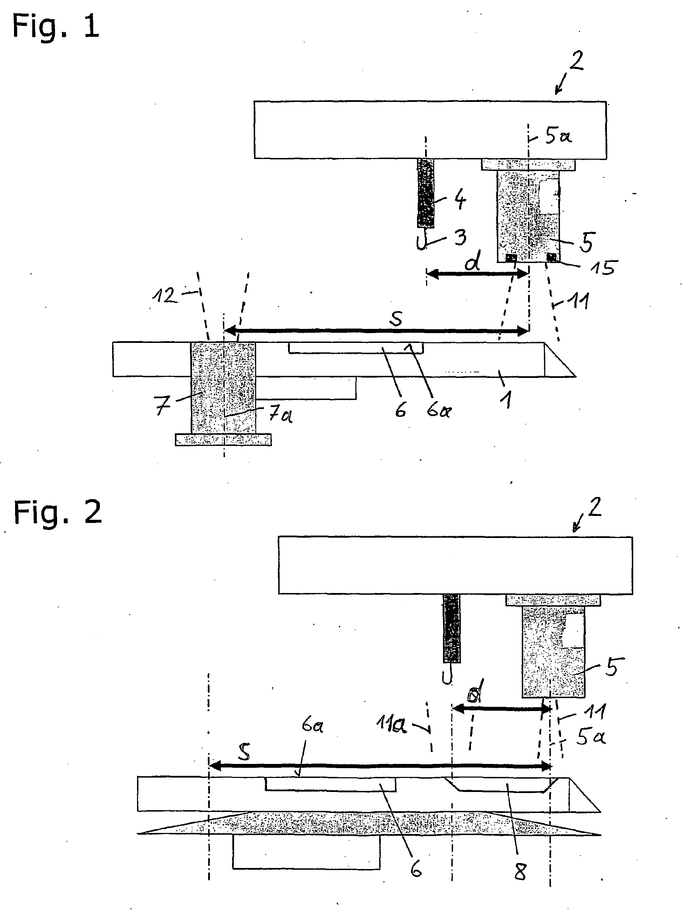

Die Vorrichtung von Fig. 1 besteht aus einer Aufnahme 1 für ein Werkstück 6, an dem die Messungen durchzuführen sind, das in einer Werkstückebene 6a angeordnet ist. In einem Messkopf 2 ist ein Werkzeug 3 in der Form eines Hakens über eine Zugkrafterfassungseinrichtung 4 aufgehängt. Weiters ist an dem Messkopf 2 eine Kamera 5 befestigt, deren Erfassungsbereich mit 11 angedeutet ist. Der mechanische Offset d ist als Abstand der Achse 5a der Kamera 5 von dem Werkzeug 3 definiert. In der Aufnahme 5 ist eine weitere Kamera 7 mit einem nach oben gerichteten Erfassungskegel 12 befestigt, in den sowohl das Werkzeug 3 als auch Referenzpunkte 15 bringbar sind, die an der Kamera 5 und damit am Messkopf 2 angebracht sind.

Der Kalibriervorgang kann nun so durchgeführt werden, dass durch Bewegung des Messkopfes 2 zunächst das Werkzeug 3 auf die optische Achse 7a der weiteren Kamera 7 ausgerichtet wird und danach unter Zuhilfenahme der Referenzpunkte 15, die Achse 5a der Kamera 5 mit der Achse 7a in Übereinstimmung gebracht wird. Dies bedeutet, dass der optische Offset s zwischen den Achsen 5a, 7a für den Fall bestimmt wird, in dem die Achse 7a der weiteren Kamera 7 auf das Werkzeug 3 ausgerichtet ist. In diesem Fall stimmen der mechanische Offset d und der optische Offset s überein, so dass die Relativposition zwischen Werkzeug 3 und optischer Achse 5a der Kamera 5 genau bestimmbar ist. Danach wird der Messkopf 2 so bewegt, dass das Werkstück 6 erfasst wird und mit Hilfe einer Bilderkennungssoftware die einzelnen Messpunkte festgestellt und ausgewählt werden. Aufgrund der genauen Kenntnis des mechanischen Offsets d kann nun das Werkzeug 3 exakt auf die entsprechenden Punkte zubewegt werden. Bei der Durchführung des Verfahrens ist es möglich, nach einer einmaligen Kalibrierung mehrere Messvorgänge durchzuführen, solange man davon ausgehen kann, dass der mechanische Offset d unverändert bleibt. Stellt sich heraus, dass nach einer bestimmten Anzahl von Messvorgängen oder auch nach einem einzigen Messvorgang der mechanische Offset d unzulässigen Veränderungen unterworfen ist, so muss die Kalibrierung nach einer entsprechenden Anzahl von Messvorgängen wiederholt werden oder im Extremfall vor jedem einzelnen Messvorgange eine Kalibrierung durchgeführt werden.

Bei der Ausführungsvariante von Fig. 2 erfolgt die Kalibrierung dadurch, dass die Kamera 5 auf ein optisches Prisma 8 gerichtet wird, das die Strahlen 11 der Kamera 5 umlenkt und bei 11a auf die Spitze des Werkzeuges 3 richtet.

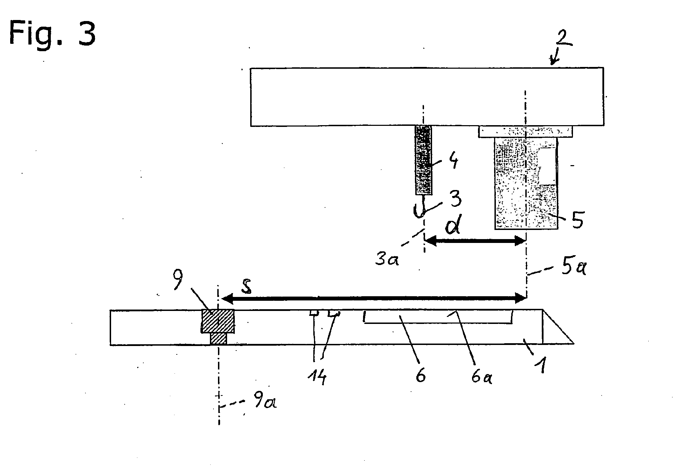

Bei der Ausführungsvariante von Fig. 3 erfolgt die Kalibrierung dadurch, dass der Messkopf bei der Kalibrierung so bewegt wird, dass das Werkzeug 3 in eine Kalibrierungsöffnung 9 abgesenkt werden kann. Sensoren, wie etwa Dehnmessstreifen in der Zugkrafterfassungseinrichtung 4 werden eingesetzt, um eine genaue Übereinstimmung der Achse 9a der Kalibrierungsöffnung 9 mit einer Achse 3a zu erreichen, in der das Werkzeug 3 angeordnet ist. Der mechanischen Offset d kann in diesem Fall dadurch bestimmt werden, dass die Kamera 5 die Position von weiteren Referenzpunkten 14 bestimmt, deren Relativlage in Bezug auf die Kalibrierungsöffnung 9 bekannt sind. Es ist aber in gleicher Weise möglich, nach dem Einführen des Werkzeuges 3 in die Kalibrierungsöffnung 9 eine weitere Verschiebung des Messkopfes 2 so durchzuführen, dass die Achse 5a der Kamera 5 mit der Achse 9a der Kalibrierungsöffnung 9 in Übereinstimmung kommt. In diesem Fall sind weitere Referenzpunkte 14 nicht erforderlich.

Die erfindungsgemäße Vorrichtung ermöglicht es, das Messverfahren schnell, zuverlässig und genau durchzuführen. Einzelmesswerte werden mit Fehlercodierung dokumentiert und statistisch mit Minimal- und Maximalwerten, sowie Standardabweichung Cpk und dergleichen ausgewertet. Anstelle von zerstörenden Tests können auch zerstörungsfreie Tests durchgeführt werden, bei denen die Kraft begrenzt wird, mit denen die einzelnen Bondings getestet werden. Der Testvorgang läuft vollautomatisch ab und wird softwaremäßig dokumentiert. Weiters besitzt die erfindungsgemäße Vorrichtung einen sehr kompakten Aufbau mit ergonomischer und verblüffend einfacher Bedienbarkeit.

## Patentansprüche

1. Vorrichtung zur Prüfung von Werkstücken (6), insbesondere von Schaltplatinen mit einem Werkzeug (3), das mechanisch mit dem Werkstück (6) in Eingriff zu bringen ist und das in einem Messkopf (2) eingespannt ist, der relativ zum Werkstück (6) in einer Werkstückebene bewegbar ist, und mit einer optischen Beobachtungseinrichtung zur Steuerung des Messkopfes (2), **dadurch gekennzeichnet, dass** die optische Beobachtungseinrichtung als Kamera (5) ausgebildet ist, die am Messkopf (2) angebracht ist und die eine optische Achse (5a) aufweist, die im Wesentlichen senkrecht auf die Werkstückebene (6a) ist, und dass eine Kalibrierungseinrichtung vorgesehen ist, die den mechanischen Offset (d), das ist der Abstand des Werkzeuges (3) von der optischen Achse (5a) der Kamera (5), bestimmt.

2. Vorrichtung nach Anspruch 1, **dadurch gekennzeichnet, dass** die Kalibrierungseinrichtung als weitere Kamera (7) ausgebildet ist, die relativ zum Messkopf (2) beweglich und so ausrichtbar ist, dass das Werkzeug (3) und Referenzpunkte (15) des Messkopfes (2) von der weiteren Kamera (7) erfassbar sind, wobei die optische Achse (7a) der weiteren Kamera (7) vorzugsweise parallel zur optischen Achse (5a) der Kamera (5) ausgerichtet ist, die die optische Beobachtungseinrichtung darstellt.

3. Vorrichtung nach Anspruch 1, **dadurch gekennzeichnet, dass** die Kalibrierungseinrichtung als optisches Prisma (8) ausgebildet ist, durch das das Werkzeug (3) von der Kamera (5) beobachtbar ist.

4. Vorrichtung nach Anspruch 1, **dadurch gekennzeichnet, dass** die Kalibrierungseinrichtung als Kalibrierungsöffnung (9) in einer Aufnahme (1) für das Werkstück (6) ausgebildet ist, in welche Kalibrierungsöffnung (9) das Werkzeug (3) einführbar ist und dass die Kalibrierungsöffnung (9) durch die Kamera (5) optisch erfassbar ist und dass das Werkzeug (3) vorzugsweise über eine Messeinrichtung (4) verfügt, die zur Steuerung der Einführbewegung in die Kalibrierungsöffnung (9) ausgebildet ist.

5. Vorrichtung nach Anspruch 4, **dadurch gekennzeichnet, dass** die Kalibrierungsöffnung (9) als sich nach oben konisch erweiternd ausgebildet ist.

6. Vorrichtung nach einem der Ansprüche 1 bis 5, **dadurch gekennzeichnet, dass** das Werkzeug (3) als Haken ausgebildet ist, der über eine Zugkrafterfassungseinrichtung (4) am Messkopf (2) befestigt ist.

7. Vorrichtung nach einem der Ansprüche 1 bis 6, **dadurch gekennzeichnet, dass** die Werkstückebene (6a) in Gebrauchslage der Vorrichtung im Wesentlichen waagrecht ist und dass das Werkzeug (3) im Messkopf (2) senkrecht beweglich angeordnet ist.

8. Vorrichtung nach einem der Ansprüche 1 bis 7, **dadurch gekennzeichnet, dass** das Werkzeug (3) gegenüber dem Messkopf (2) drehbar angeordnet ist.

9. Vorrichtung nach einem der Ansprüche 1 bis 8, **dadurch gekennzeichnet, dass** die Vorrichtung mit einer Steuerung basierend auf einer Bilderkennungseinrichtung zur automatischen Bewegung des Werkzeuges (3) ausgestattet ist.

10. Verfahren zur Prüfung von Werkstücken (6) mit folgenden Schritten:
- Einspannen eines Werkstückes (6);
- Bereitstellen eines Werkzeuges (3) auf einem Messkopf (2), der relativ zum Werkstück (6) gelagert ist;
- Führen des Werkzeuges (3) zu den zu untersuchenden Punkten des Werkstückes (6), geführt durch eine optische Beobachtungseinrichtung;
- Durchführen der Messung an den zu untersuchenden Punkten des Werkstückes (6);
**dadurch gekennzeichnet, dass** die Führung des Werkzeuges (3) durch eine Kamera (5) erfolgt, die gemeinsam mit dem Werkzeug (3) relativ zum Werkstück (6) beweglich ist und dass die Relativposition der Kamera (5) zum Werkzeug (3) durch eine Kalibrierungseinrichtung (7, 8, 9) erfasst wird.

11. Verfahren nach Anspruch 10, **dadurch gekennzeichnet, dass** vor jeder Messung eine Kalibrierung erfolgt.

12. Verfahren nach einem der Ansprüche 10 oder 11, **dadurch gekennzeichnet, dass** das Werkzeug (3) drehbar gelagert ist und dass die Kalibrierung in verschiedenen Winkelstellungen des Werkzeuges (3) in Bezug auf eine zur Werkstückebene (6a) im Wesentlichen normale Achse erfolgt.

13. Verfahren nach einem der Ansprüche 10 bis 12, **dadurch gekennzeichnet, dass** die Kalibrierung durch eine weitere Kamera (7) erfolgt, die auf das Werkzeug (3) und auf Referenzpunkte (15) des Messkopfes (2) gerichtet wird.

14. Verfahren nach einem der Ansprüche 10 bis 12, **dadurch gekennzeichnet, dass** die Kalibrierung durch ein Prisma (8) erfolgt, auf das die Kamera (5) so gerichtet wird, dass das Werkzeug (3) erfasst wird.

15. Verfahren nach einem der Ansprüche 10 bis 12, **dadurch gekennzeichnet, dass** die Kalibrierung durch eine Kalibrierungsöffnung (9) erfolgt, in die das Werkzeug (3) eingeführt wird und die von der Kamera (5) erfasst wird, wobei die Kamera (5) während des Einführens des Werkzeuges (3) in die Kalibrierungsöffnung (9) vorzugsweise auf weitere Referenzpunkte (15) gerichtet wird, die in einer vorbestimmten Relativposition zur Kalibrierungsöffnung (9) angeordnet sind.

16. Verfahren nach einem der Ansprüche 10 bis 15, **dadurch gekennzeichnet, dass** der Messvorgang automatisch unter Zuhilfenahme eines Bilderkennungsverfahrens durchgeführt wird.

## Claims

1. Device for examining workpieces (6), in particular circuit cards, comprising a tool (3) which can be mechanically engaged with the workpiece (6) and which is clamped in a measuring head (2) which is movable relative to the workpiece (6) in a workpiece plane, and comprising an optical observation device for controlling the measuring head (2), **characterised in that** the optical observation device is embodied as a camera (5) which is attached to the measuring head (2) and which has an optical axis (5a) which is substantially perpendicular to the workpiece plane (6a), and **in that** there is provided a calibration device which determines the mechanical offset (d) which is the distance of the tool (3) from the optical axis (5a) of the camera (5).

2. Device according to claim 1, **characterised in that** the calibration device is embodied as a further camera (7) which is movable relative to the measuring head (2) and orientable in such a way that the tool (3) and reference points (15) of the measuring head (2) can be detected by the further camera (7), wherein the optical axis (7a) of the further camera (7) is oriented preferably parallel to the optical axis (5a) of the camera (5) which is the optical observation device.

3. Device according to claim 1, **characterised in that** the calibration device is embodied as an optical prism (8) through which the camera (5) is able to observe the tool (3).

4. Device according to claim 1, **characterised in that** the calibration device is embodied as a calibration opening (9) in a receptacle (1) for the workpiece (6), into which calibration opening (9) the tool (3) can be introduced, and **in that** the camera (5) is able optically to detect the calibration opening (9), and **in that** the tool (3) preferably has a measuring device (4) which is embodied for controlling the movement of introduction into the calibration opening (9).

5. Device according to claim 4, **characterised in that** the calibration opening (9) is embodied so as to extend conically upward.

6. Device according to any one of claims 1 to 5, **characterised in that** the tool (3) is embodied as a hook which is fastened to the measuring head (2) via a tensile force detection device (4).

7. Device according to any one of claims 1 to 6, **characterised in that** the workpiece plane (6a) is substantially horizontal in the use position of the device and **in that** the tool (3) is arranged in the measuring head (2) so as to be able to move vertically.

8. Device according to any one of claims 1 to 7, **characterised in that** the tool (3) is arranged so as to be able to rotate in relation to the measuring head (2).

9. Device according to any one of claims 1 to 8, **characterised in that** the device is equipped with a controller based on an image recognition device for automatically moving the tool (3).

10. Method for examining workpieces (6) including the following steps:
- clamping a workpiece (6);
- providing a tool (3) on a measuring head (2) which is mounted relative to the workpiece (6);
- guiding the tool (3) to the points to be examined of the workpiece (6), guided by an optical observation device;
- performing the measurement on the points to be examined of the workpiece (6);
**characterised in that** the tool (3) is guided by a camera (5) which is movable, together with the tool (3), relative to the workpiece (6) and **in that** the position of the camera (5) relative to the tool (3) is detected by a calibration device (7, 8, 9).

11. Method according to claim 10, **characterised in that** a calibration is carried out prior to each measurement.

12. Method according to either claim 10 or claim 11, **characterised in that** the tool (3) is rotatably mounted and **in that** the calibration is carried out in various angular positions of the tool (3) in relation to an axis which is substantially normal to the workpiece plane (6a).

13. Method according to any one of claims 10 to 12, **characterised in that** the calibration is carried out by a further camera (7) which is directed toward the tool (3) and toward reference points (15) of the measuring head (2).

14. Method according to any one of claims 10 to 12, **characterised in that** the calibration is carried out through a prism (8) toward which the camera (5) is directed in such a way that the tool (3) is detected.

15. Method according to any one of claims 10 to 12, **characterised in that** the calibration is carried out through a calibration opening (9) into which the tool (3) is introduced and which is detected by the camera (5), wherein the camera (5) is directed, during the introduction of the tool (3) into the calibration opening (9), preferably toward further reference points (15) which are arranged in a predetermined position relative to the calibration opening (9).

16. Method according to any one of claims 10 to 15, **characterised in that** the measuring process is carried out automatically with the aid of an image recognition method.

## Revendications

1. Dispositif de vérification de pièces (6) notamment de platines de circuit à l'aide d'un outil (3), mis en prise mécaniquement avec la pièce (6) et fixé à une tête de mesure (2) mobile par rapport à la pièce (6) dans un plan de la pièce et comportant une installation optique d'observation pour commander la tête de mesure (2),
**caractérisé en ce que**
l'installation d'observation optique est une caméra (5) installée sur la tête de mesure (2) et ayant un axe optique (5a) pratiquement perpendiculaire au plan (6a) de la pièce, et
il est prévu une installation de calibrage qui définit le décalage mécanique (d) c'est-à-dire la distance de l'outil (3) par rapport à l'axe optique (5a) de la caméra (5).

2. Dispositif selon la revendication 1,
**caractérisé en ce que**
l'installation de calibrage est réalisée sous la forme d'une autre caméra (7) mobile par rapport à la tête de mesure (2) et qui peut être alignée par rapport à celle-ci,
l'outil (3) et des points de référence (15) de la tête de mesure (2) sont saisis par l'autre caméra (7),
l'axe optique (7a) de l'autre caméra (7) est aligné de préférence parallèlement à l'axe optique (5a) de la caméra (5) et il constitue l'installation optique d'observation.

3. Dispositif selon la revendication 1,
**caractérisé en ce que**
l'installation de calibrage est réalisée sous la forme d'un prisme optique (8) par lequel la caméra (5) observe l'outil (3).

4. Dispositif selon la revendication 1,
**caractérisé en ce que**
l'installation de calibrage réalisée sous la forme d'un orifice de calibrage (9) dans un support (1) pour la pièce (6) et l'outil (3) s'introduisant dans l'orifice de calibrage (9),
l'orifice de calibrage (9) est saisi optiquement par la caméra (5), et l'outil (3) dispose de préférence d'une installation de mesure (4) pour commander son mouvement d'introduction dans l'orifice de calibrage (9).

5. Dispositif selon la revendication 4,
**caractérisé en ce que**
l'orifice de calibrage (9) est un orifice conique qui s'élargit vers le haut.

6. Dispositif selon les revendications 1 à 5,
**caractérisé en ce que**
l'outil (3) est en forme de crochet fixé à la tête de mesure (2) par l'intermédiaire d'une installation (4) de saisie de la force de traction.

7. Dispositif selon les revendications 1 à 6,
**caractérisé en ce que**
le plan (6a) de la pièce, en position d'utilisation du dispositif est pratiquement horizontal et l'outil (3) est mobile verticalement dans la tête de mesure (2).

8. Dispositif selon les revendications 1 à 7,
**caractérisé en ce que**
l'outil (3) est monté à rotation par rapport à la tête de mesure (2).

9. Dispositif selon les revendications 1 à 8,
**caractérisé en ce que**
le dispositif est équipé d'une commande fondée sur une installation de reconnaissance d'image pour déplacer automatiquement l'outil (3).

10. Procédé de vérification de pièces (6) comprenant les étapes suivantes :
- fixation d'une pièce (6),
- fourniture d'un outil (3) à une tête de mesure (2) montée de manière relative par rapport à la pièce (6),
- guidage de l'outil (3) vers les points à examiner de la pièce (6), le guidage étant fait par l'installation optique d'observation,
- exécution de la mesure aux points à examiner de la pièce (6),
**caractérisé en ce que**
le guidage de l'outil (3) se fait par une caméra (5) mobile en commun avec l'outil (3) par rapport à la pièce (6), et
la position relative de la caméra (5) par rapport à l'outil (3) est saisie par une installation de calibrage (7, 8, 9).

11. Procédé selon la revendication 10,
**caractérisé en ce qu'**
on effectue un calibrage avant chaque mesure.

12. Procédé selon la revendication 10 ou 11,
**caractérisé en ce que**
l'outil (3) est monté de manière mobile et le calibrage se fait dans différentes positions angulaires de l'outil (3) par rapport à un axe pratiquement normal au plan (6a) de la pièce.

13. Procédé selon les revendications 10 à 12,
**caractérisé en ce que**
le calibrage est fait par une autre caméra (7) dirigée vers l'outil (3) et vers des points de référence (15) de la tête de mesure (2).

14. Procédé selon les revendications 10 à 12,
**caractérisé en ce que**
le calibrage se fait à travers un prisme (8) vers lequel est dirigée la caméra (5) pour saisir l'outil (3).

15. Procédé selon les revendications 10 à 12,
**caractérisé en ce que**
le calibrage se fait à travers un orifice de calibrage (9) dans lequel on introduit l'outil (3) et il est saisi par la caméra (5),
la caméra (5) est dirigée de préférence vers d'autres points de référence (15) au cours de l'introduction de l'outil (3) dans l'orifice de calibrage (9), points situés dans une position relative prédéfinie par rapport à l'orifice de calibrage (9).

16. Procédé selon les revendications 10 à 15,
**caractérisé en ce que**
l'opération de mesure est faite automatiquement à l'aide d'un procédé de reconnaissance d'image.
